# EUROPEAN PATENT APPLICATION

(11) **EP 4 776 772 A1**
(43) Date of publication of application: **15.07.2026**
(21) Application number: 25221658.5
(22) Date of filing: 09.12.2025
(51) Int. Cl.: H05K 7/20

(54) **COOLING PLATE**

(30) Priority: 17.12.2024 JP 2024220918
(71) Applicant: AISIN CORPORATION, Aichi 448-8650 (JP)
(72) Inventor: NAGAI, Yuki, Kariya, 448-8650 (JP); KOASHI, Hidefumi, Kariya, 448-8650 (JP); MIZUNO, Yuya, Kariya, 448-8650 (JP); SUGIMOTO, Noriaki, Kariya, 448-8650 (JP)
(74) Representative: Kramer Barske Schmidtchen Patentanwälte PartG mbB

(57) **Abstract**

Provided is a cooling plate (A) for cooling an electronic component (8) to be cooled by a cooling liquid (F) flowing through a cooling flow path (P). The cooling plate includes: a plate member (10, 11) having a plate surface (10b, 15a) with which the electronic component comes into contact. The cooling flow path is formed in the plate member. The cooling flow path includes a first cooling flow path portion (21), a second cooling flow path portion (S) located downward further than the first cooling flow path portion in a gravity direction and downstream in a flow direction of the cooling liquid, and a supply flow path portion (23) inclined downward to connect the first cooling flow path portion and the second cooling flow path portion. A plurality of fins (16) formed on the plate member are housed in the second cooling flow path portion. The electronic component comes into contact with a portion of the plate surface that is close to the second cooling flow path portion.

## Description

### TECHNICAL FIELD

This disclosure relates to a cooling plate.

### BACKGROUND DISCUSSION

JP 2018-182930A (Reference 1) discloses an inverter in which a power module including a switching element is housed in a housing chamber of a case, and the power module is cooled by a cooling unit provided below the case.

In the inverter, heat dissipation fins of the power module are exposed downward from an opening formed in a bottom wall of the case, and a cooling medium is supplied to the cooling unit, thereby cooling the inverter by bringing the cooling medium into contact with the heat dissipation fins.

Taking a hybrid electric vehicle ((HEV), a plug-in hybrid electric vehicle ((PHEV), a battery electric vehicle ((BEV), and the like, which can run on power, as an example, these vehicles include a power control system that controls power supplied to a traveling motor and enables power control such as charging of a battery of a vehicle body.

Such a power control system provided in the vehicle includes an inverter, a DCDC converter, a charger (OBC), and the like, and the inverter, the DCDC converter, the charger (OBC), and the like serve as heat sources and cause the temperature in the system to increase, so that a configuration capable of satisfactorily cooling these heat sources is required. In particular, efficient heat dissipation is required for an inverter that generates large heat during operation, such as a large-capacity inverter.

Therefore, as described in Reference 1, it is conceivable to adopt a configuration in which heat is dissipated by bringing the cooling medium into contact with the heat dissipation fins. In Reference 1, since the heat dissipation fins are disposed to be fitted into the opening of the case, the cooling unit includes a duct attached to the bottom wall of the case, cooling water from the outside is sent obliquely upward by the duct and brought into contact with the heat dissipation fins inside the opening, and the cooling water in contact with the heat dissipation fins is sent obliquely downward by the duct.

In a configuration in which a flow of a cooling liquid is controlled by using such a duct, since a member (duct) for determining a flow direction of the cooling liquid is required, there is a concern that the number of components increases and the size of the entire device increases.

A need thus exists for a cooling plate that enables efficient cooling without causing an increase in size.

### SUMMARY

According to an aspect of this disclosure, there is provided a cooling plate for cooling an electronic component to be cooled by a cooling liquid flowing through a cooling flow path, the cooling plate including: a plate member having a plate surface with which the electronic component comes into contact, in which the cooling flow path is formed in the plate member, the cooling flow path includes a first cooling flow path portion, a second cooling flow path portion located downward further than the first cooling flow path portion in a gravity direction and downstream in a flow direction of the cooling liquid, and a supply flow path portion inclined downward to connect the first cooling flow path portion and the second cooling flow path portion, a plurality of fins formed on the plate member are housed in the second cooling flow path portion, and the electronic component comes into contact with a portion of the plate surface that is close to the second cooling flow path portion.

According to this configuration, since the cooling flow path is formed in the plate member, a duct or a conduit for forming a flow path is not required, and the number of components can be reduced. In this configuration, the second cooling flow path portion is provided downward further than the first cooling flow path portion in the gravity direction and downstream in the flow direction of the cooling liquid, and the electronic component comes into contact with the portion of the plate surface that is close to the second cooling flow path portion. In this configuration, since the cooling liquid from the first cooling flow path portion flows downward through the supply flow path portion in an inclined orientation to be supplied to the second cooling flow path portion, the flow is promoted by the weight of the cooling liquid, the cooling liquid is easily brought into contact with the plurality of fins in the second cooling flow path portion, and the heat of the electronic component is absorbed to easily reduce the temperature. Therefore, the cooling plate that enables efficient cooling without causing an increase in size can be implemented.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a perspective view illustrating a schematic configuration of a power control unit including a cooling plate;
Fig. 2 is a perspective view of a lower plate member as viewed from below;
Fig. 3 is a plan view of a cooling space;
Fig. 4 is a longitudinal-sectional side view of a first upper flow path, a supply flow path portion, and the cooling space; and
Fig. 5 is a plan view showing a positional relationship between a plurality of supply hole portions and a plurality of pin fins.

### DETAILED DESCRIPTION

Hereinafter, embodiments of a cooling plate disclosed here will be described with reference to the drawings. The present embodiment is not limited to the following embodiments, and various modifications are possible without departing from the spirit and scope disclosed here.

Hereinafter, embodiments disclosed here will be described with reference to the drawings. In the following description, an up-down direction indicates an up-down direction in a gravity direction.

### Basic Configuration

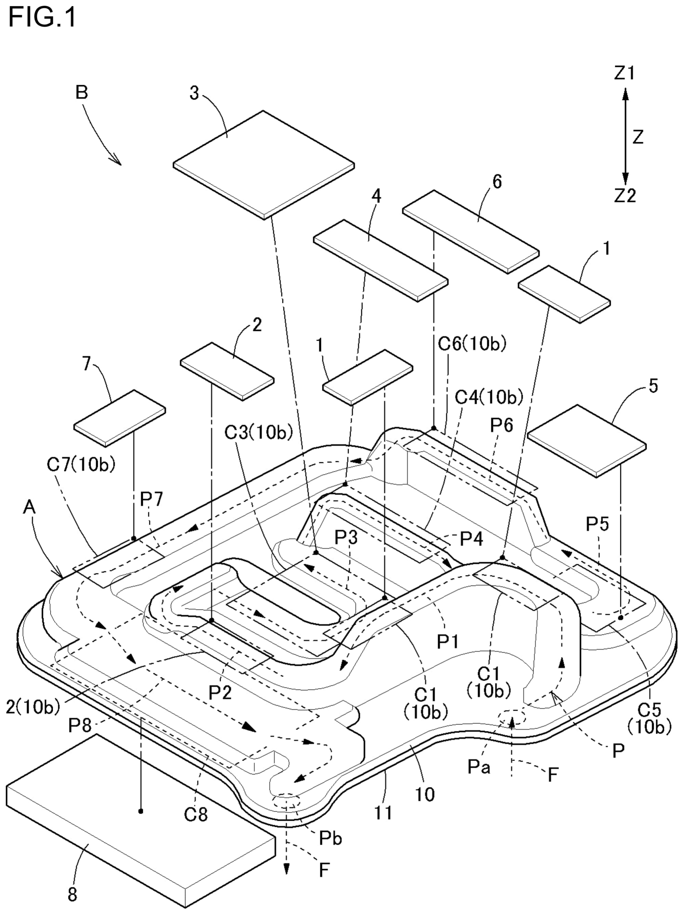

Fig. 1 illustrates a power control unit B including a cooling plate A provided in a vehicle (not illustrated) such as a hybrid electric vehicle (HEV), a plug-in hybrid electric vehicle ((PHEV), or a battery electric vehicle (BEV), which can run on power.

As illustrated in Fig. 1, the power control unit B according to the present embodiment includes the cooling plate A and, as electronic components to be cooled by the cooling plate A, a pair of primary power modules 1, a secondary power module 2, a transformer coil 3, a first FET 4, a PFC coil 5, a second FET 6, a secondary coil 7, and an inverter 8 (an example of the electronic component). Each of the pair of primary power modules 1, the secondary power module 2, the transformer coil 3, the first FET 4, the PFC coil 5, the second FET 6, and the secondary coil 7 is formed to a predetermined size in the up-down direction, but in the drawing, these electronic components are depicted in a form of plates.

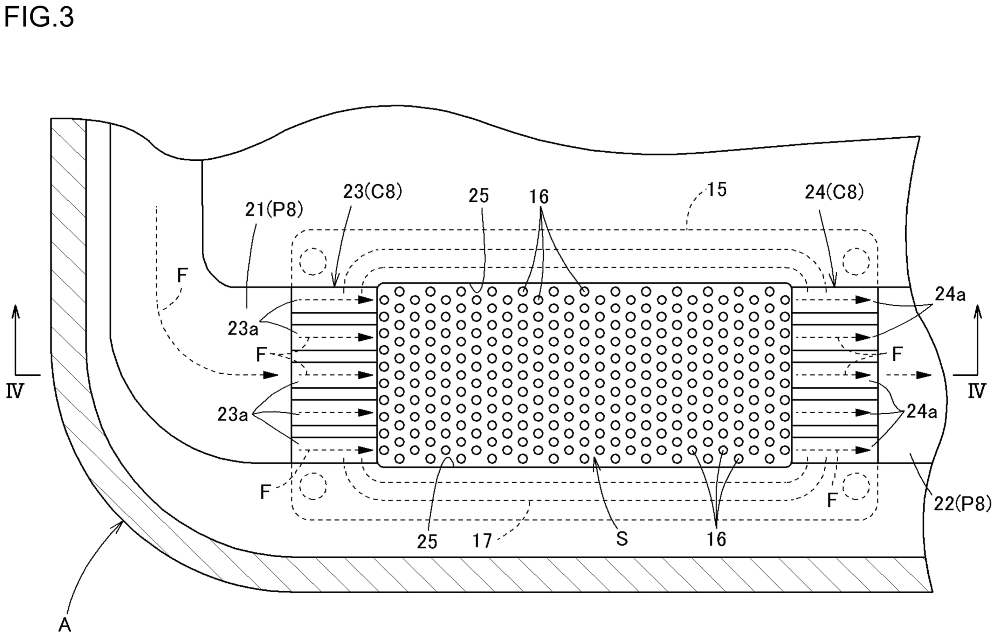

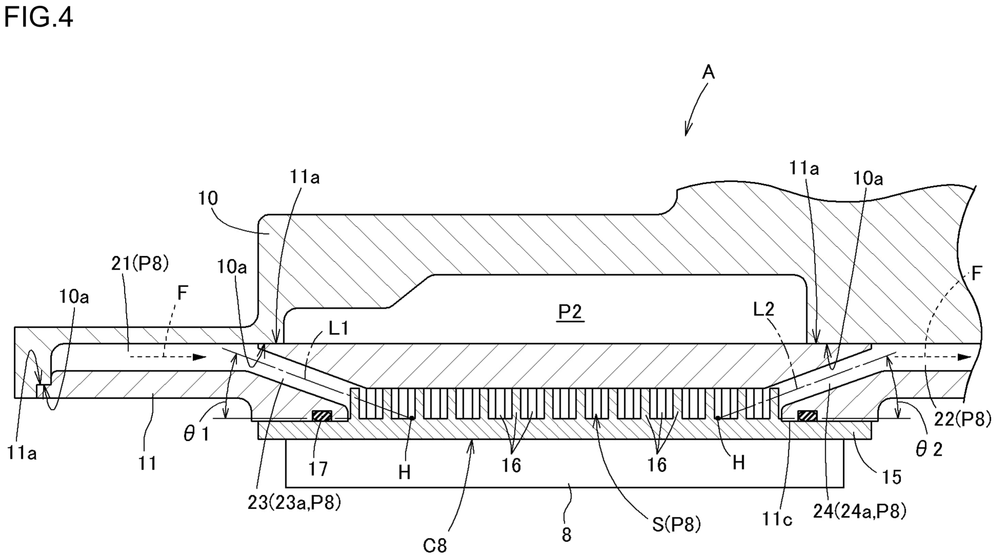

The cooling plate A includes plate members 10 and 11. Details will be described later, and the plate member is formed by joining outer peripheries of a pair of upper plate member 10 (an example of a second plate member) and lower plate member 11 (an example of a first plate member) by welding or the like. The cooling plate A is formed with a cooling flow path P through which a cooling liquid F flows as illustrated in Figs. 3 and 4, and the like in order to cool heat generated by the plurality of electronic components forming the power control unit B. The lower plate member 11 includes a supply port Pa at one end of the cooling flow path P and a discharge port Pb at the other end of the cooling flow path P. The cooling liquid F is assumed to be water, but includes, in addition to water, an antifreeze containing ethylene glycol or the like as a main component, cooling water such as long-life coolant (LLC) containing propylene glycol or the like, or cooling oil containing insulating oil such as paraffinic oil. That is, the cooling liquid F is a general term for cooling water and cooling oil.

The cooling plate A is provided in a vehicle in an orientation illustrated in Fig. 1. Therefore, an up-down relationship of each portion of the cooling plate A will be described according to the orientation. Hereinafter, an up-down direction is referred to as a Z direction, a side and a direction in which the upper plate member 10 is disposed with respect to the lower plate member 11 are referred to as a Z1 side and a Z1 direction, and a side and a direction in which the lower plate member 11 is disposed with respect to the upper plate member 10 are referred to as a Z2 side and a Z2 direction. At this time, a Z2 direction is a gravity direction.

As illustrated in Fig. 1, the upper plate member 10 has a plate surface 10b that comes into contact with (or may be close to) each of the primary power module 1, the secondary power module 2, the transformer coil 3, the first FET 4, the PFC coil 5, the second FET 6, and the secondary coil 7. The plate surface 10b is a part of a first cooling portion C1 with which the primary power module 1 comes into contact, a second cooling portion C2 with which the secondary power module 2 comes into contact, a third cooling portion C3 with which the transformer coil 3 comes into contact, a fourth cooling portion C4 with which the first FET 4 comes into contact, a fifth cooling portion C5 with which the PFC coil 5 comes into contact, a sixth cooling portion C6 with which the second FET 6 comes into contact, and a seventh cooling portion C7 with which the secondary coil 7 comes into contact. In the lower plate member 11, a lower surface 15a of a plate-shaped body 15 integrated on the Z2 side (an example of the plate surface) is a part of an eighth cooling portion C8 that comes into contact with the inverter 8. The first cooling portion C1 to the eighth cooling portion C8 may be collectively referred to as a cooling portion C.

The cooling flow path P includes a first flow path portion P1, a second flow path portion P2, a third flow path portion P3, a fourth flow path portion P4, a fifth flow path portion P5, a sixth flow path portion P6, a seventh flow path portion P7, and an eighth flow path portion P8 for supplying the cooling liquid F to the vicinity of the plurality of cooling portions C. The first flow path portion P1 to the eighth flow path portion P8 may be collectively referred to as a cooling flow path P.

That is, in the first flow path portion P1 to the seventh flow path portion P7 among the plurality of cooling flow paths P, the cooling liquid F flows in the vicinity of the plate surface 10b for heat exchange of the upper plate member 10, so that the electronic components that come into contact with (or are close to) the cooling portion C can be cooled. Specifically, the first flow path portion P1 to the seventh flow path portion P7 are formed directly below (on the Z2 side of) the plate surface 10b of the upper plate member 10 in the first cooling portion C1 to the seventh cooling portion C7, respectively. A thickness of a wall between the plate surface 10b and the cooling flow path P in the upper plate member 10 (a distance between the plate surface 10b and the cooling flow path P) is preferably as thin as possible within a range in which strength required for the upper plate member 10 can be ensured. Accordingly, the cooling liquid F flowing through the cooling flow path P can effectively cool the electronic components. A configuration of the eighth cooling portion C8 will be described later.

With such a configuration, in the cooling plate A, when the cooling liquid F is supplied to the supply port Pa, the cooling liquid F flows to the first flow path portion P1 to the eighth flow path portion P8, absorbs heat of the electronic components in the first cooling portion C1 to the eighth cooling portion C8 corresponding thereto, cools the plurality of electronic components, and then is discharged from the discharge port Pb.

In particular, the electronic components of the primary power modules 1, the secondary power module 2, the transformer coil 3, the first FET 4, the PFC coil 5, the second FET 6, and the secondary coil 7 are supported by one substrate or a plurality of substrates.

With this configuration, a positional relationship between the substrate and the upper plate member 10 in the cooling plate A is set such that the primary power modules 1, the secondary power module 2, the transformer coil 3, the first FET 4, the PFC coil 5, the second FET 6, and the secondary coil 7 are disposed in contact with or in close proximity to the first cooling portion C1, the second cooling portion C2, the third cooling portion C3, the fourth cooling portion C4, the fifth cooling portion C5, the sixth cooling portion C6, and the seventh cooling portion C7 corresponding thereto, respectively.

The cooling plate A may be configured such that a heat conductive sheet or a gap filler is sandwiched between the cooling portion C for heat exchange and the substrate, the electronic component, or the like in order to absorb heat of the electronic components.

### Plate Member

As illustrated in Figs. 1, 2, and 4, the plate members are the lower plate member 11 (an example of the first plate member) made of a metal material such as aluminum, and the upper plate member 10 (the second plate member) disposed on the lower plate member 11. A boundary surface where a first facing surface 11a of the lower plate member 11 and a second facing surface 10a of the upper plate member 10 come into contact with each other is referred to as a mating surface, and the cooling flow path P is formed in the mating surface. The lower plate member 11 includes a plate-shaped base portion 11b and a rectangular convex portion 11c protruding in a rectangular shape from a surface of the base portion 11b on a side (the Z2 side) facing the upper plate member 10. In the present embodiment, the lower plate member 11 has the first facing surface 11a on each of the base portion 11b and the rectangular convex portion 11c.

As illustrated in Fig. 4, the cooling flow path P is formed by a recessed space in at least one of mating surfaces of the first facing surface 11a of the lower plate member 11 and the second facing surface 10a of the upper plate member 10. The recessed space is a recess formed in at least one of the first facing surface 11a and the second facing surface 10a, and the recess includes a groove, a notch portion, and a hole portion.

The cooling plate A is formed by overlapping the first facing surface 11a formed on the lower plate member 11 and the second facing surface 10a formed on the upper plate member 10 so as to be in close contact with each other. An outer periphery of the mating surface (an outer periphery of the cooling plate A in plan view) is welded by a laser beam with the first facing surface 11a and the second facing surface 10a in close contact with each other with a seal interposed therebetween.

By this welding, in the cooling plate A, the lower plate member 11 and the upper plate member 10 are integrated, and a position of the cooling flow path P formed at a boundary between the first facing surface 11a and the second facing surface 10a is fixed. Since the first facing surface 11a and the second facing surface 10a are in close contact with each other, a phenomenon in which a part of the cooling liquid F flowing through the cooling flow path P flows out along the mating surface can be prevented, and even when a part of the cooling liquid F leaks along the mating surface, a leakage amount is small, and the welded portion prevents the leakage of the cooling liquid F to the outside. For this reason, a configuration without using a seal on the mating surface is enabled.

The two plate members 10 and 11 are not limited to those in which the mating surface between the first facing surface 11a and the second facing surface 10a is formed as a single plane, and for example, in order to make the position of the cooling flow path P in the up-down direction different, the cooling plate A may be formed by using a plurality of plate members whose facing surfaces are positioned at different positions in the up-down direction.

For the plate members 10 and 11 forming the cooling plate A, the cooling plate A may be formed using a plurality of plate members 10 and 11 each having a facing surface formed thereon such that a plurality of mating surfaces at different positions in the up-down direction are connected by an obliquely oriented mating surface.

As illustrated in Fig. 4, in the cooling plate A, the second flow path portion P2 is formed in a groove shape on the second facing surface 10a of the upper plate member 10, and a first upper flow path 21 (the eighth flow path portion P8) and a second upper flow path 22 (the eighth flow path portion P8) are formed in a groove shape. A cooling space S including an opening opened to a lower surface (a surface on the Z2 side) of the lower plate member 11 is formed at a portion corresponding to the rectangular convex portion 11c of the lower plate member 11. Details will be described later, and the opening of the cooling space S is closed by the plate-shaped body 15.

The second flow path portion P2 is an upstream cooling flow path portion of the cooling flow path P that is located upstream of the first upper flow path 21 and the second upper flow path 22, and the first upper flow path 21 and the second upper flow path 22 are a downstream cooling flow path portion. The upstream cooling flow path portion and the downstream cooling flow path portion are in a positional relationship in which they do not overlap in plan view (when viewed in the Z direction), and the phenomenon of the cooling liquid F flowing between these flow path portions can be prevented. In particular, a temperature of the cooling liquid F in the second flow path portion P2 (the upstream cooling flow path portion) is lower than a temperature of the cooling liquid F in the first upper flow path 21 (the downstream cooling flow path portion) and the second upper flow path 22 (the downstream cooling flow path portion). The second flow path portion P2 is located above the mating surface, and the first upper flow path 21 and the second upper flow path 22 are located below the mating surface. That is, the second flow path portion P2 is located higher up than the first upper flow path 21 and the second upper flow path 22.

Even when the first facing surface 11a and the second facing surface 10a of the cooling plate A are formed within a predetermined tolerance range at the time of manufacturing, a gap is formed between the contact surfaces, and the cooling liquid F may slightly leak into the gap.

For example, as illustrated in Fig. 4, the cooling liquid F may leak between the second flow path portion P2 and the first upper flow path 21 on the mating surface between the first facing surface 11a of the rectangular convex portion 11c in the lower plate member 11 and the second facing surface 10a of the upper plate member 10. When the cooling liquid F leaks in this manner, the cooling liquid F tends to flow from the upper second flow path portion P2 to the lower first upper flow path 21 due to the own weight thereof. As described above, in the present embodiment, the cooling liquid F flowing through the second flow path portion P2 has a temperature lower than that of the cooling liquid F flowing through the first upper flow path 21. Therefore, even when leakage occurs, the cooling liquid F flowing through the first upper flow path 21 is supplied to the cooling space S with the temperature thereof increasing prevented, so that the cooling performance is not reduced.

Similarly, even when the cooling liquid F flows from the upstream flow path portion to the downstream flow path portion of the cooling flow path P, the cooling performance is not reduced. That is, even when the cooling plate A is in a situation where the first facing surface 11a of the lower plate member 11 and the second facing surface 10a of the upper plate member 10 are not partially in close contact with each other appropriately, the leakage of the cooling liquid F does not change a flow rate of the cooling liquid F flowing throughout the cooling plate A, and the cooling performance is not reduced. As described above, it is not necessary to excessively increase the tolerance between the first facing surface 11a and the second facing surface 10a at the time of manufacturing, and manufacturing in a simple process is enabled with a configuration in which no seal is required on the mating surface.

The cooling plate A may include a collection flow path through which the cooling liquid F leaks to the mating surface is collected and guided to the discharge port Pb.

Since the cooling plate A does not use a pipe material therein, the cooling plate A can be formed compactly as a whole without increasing the number of components. The cooling plate A has a configuration in which the cooling flow path P is formed by forming a recessed space in the mating surface. Therefore, for example, even when a flow rate of the cooling liquid F per unit time is increased depending on the specification, it is only necessary to change the design to increase a cross-sectional shape of the recessed space, and there is no inconvenience that a large-diameter pipe material is used unlike a configuration using a pipe material.

### Cooling Configuration of Inverter

As illustrated in Fig. 4, the inverter 8 produces a three-phase alternating current from power supplied from a power supply (not illustrated) and performs control to supply the three-phase alternating current to the traveling motor, and serves as a heat generating portion that generates a large amount of heat during the control.

The eighth flow path portion P8 for cooling the inverter 8 includes the first upper flow path 21 (an example of the first cooling flow path portion), the cooling space S (an example of the second cooling flow path portion) located downward further than the first cooling flow path portion and downstream in the flow direction of the cooling liquid F, and a supply flow path portion 23 inclined downward to connect the first upper flow path 21 and the cooling space S.

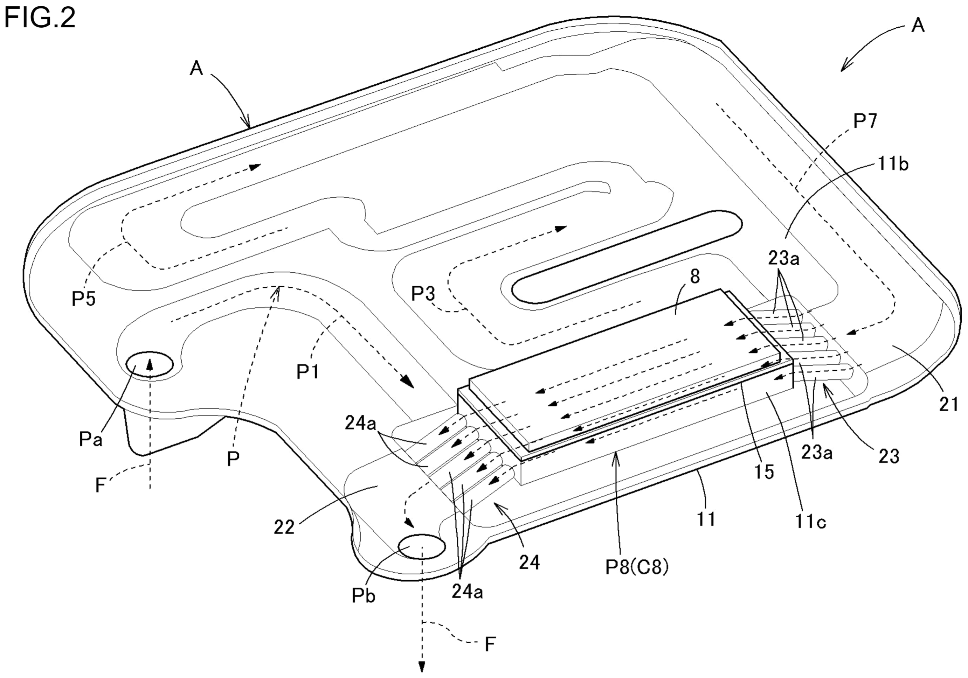

Fig. 2 clearly illustrates a configuration of the eighth flow path portion P8 when the lower plate member 11 is viewed from the lower side (the Z2 side). That is, in order to clarify five supply hole portions 23a forming the supply flow path portion 23, a side wall 25 (see Fig. 3) forming the cooling space S, the inverter 8, the plate-shaped body 15, and five discharge hole portions 24a forming a discharge flow path portion 24, wall portions thereof are extracted and drawn as a perspective view. Therefore, Fig. 2 is different from an actual shape of the lower plate member 11 when viewed from below.

As illustrated in Figs. 3 and 4, the flat plate-shaped body 15 transmitting heat of the electronic components is connected to an upper surface of the inverter 8, and a plurality of pin fins 16 are formed on a plate surface of the plate-shaped body 15. The plate-shaped body 15 and the plurality of pin fins 16 are formed of a metal material such as aluminum having high thermal conductivity.

Details of the flow of the cooling liquid F will be described later, and in the cooling plate A, the cooling liquid F flowing through the eighth flow path portion P8 comes into contact with the plate-shaped body 15 and comes into contact with the plurality of pin fins 16, so that the cooling liquid F absorbs heat generated in the inverter 8, thereby cooling the inverter 8. The eighth cooling portion C8 is formed to cool the inverter 8 by supplying the cooling liquid F in this manner.

The plurality of pin fins 16 are formed on the plate-shaped body 15 in an orientation orthogonal to the plate surface of the plate-shaped body 15 using a needle-shaped material having a circular cross-sectional shape.

As illustrated in Fig. 4, the plate-shaped body 15 is provided on a lower surface side of the lower plate member 11. Specifically, the plate-shaped body 15 is attached to close an opening of the cooling space S formed in the lower plate member 11. The plate-shaped body 15 has a size that closes the opening of the cooling space S. As described above, since the plate-shaped body 15 forms the cooling space S as the second cooling flow path portion together with the lower plate member 11, the plate-shaped body 15 can also be regarded as a part of the lower plate member 11.

The plate-shaped body 15 closes the opening of the cooling space S by being fixed to the lower plate member 11 from the lower surface side with a bolt or the like (not illustrated). The plate surface of the plate-shaped body 15 fixed in this manner is horizontal, and the plurality of pin fins 16 are housed in the cooling space S in a vertical orientation. An annular seal 17 is fitted in a region surrounding the opening of the cooling space S on the lower surface of the lower plate member 11.

As illustrated in Fig. 4, the eighth flow path portion P8 includes the cooling space S, and the upstream first upper flow path 21 and the downstream second upper flow path 22 that sandwich the cooling space S therebetween in a flow direction of the cooling liquid F in plan view. The eighth flow path portion P8 includes the supply flow path portion 23 disposed in an inclined orientation between the first upper flow path 21 and the cooling space S, and the discharge flow path portion 24 disposed in an inclined orientation between the cooling space S and the second upper flow path 22. In the present embodiment, the cooling space S corresponds to "another cooling flow path portion located downstream of the downstream cooling flow path portion in the flow direction of the cooling liquid".

The first upper flow path 21 and the second upper flow path 22 are each formed as a recessed space formed in the second facing surface 10a of the upper plate member 10 and a recessed space having a groove shape in the first facing surface 11a of the lower plate member 11. The first upper flow path 21 and the second upper flow path 22 are disposed at a position higher than the cooling space S.

That is, the supply flow path portion 23 includes an upstream side communicating with the first upper flow path 21 formed as a groove-shaped recessed space in the second facing surface 10a, and a downstream end portion communicating with the cooling space S. Similarly, the discharge flow path portion 24 includes an upstream end portion communicating with the cooling space S, and a downstream side communicating with the second upper flow path 22 formed as a groove-shaped recessed space on the second facing surface 10a.

The second flow path portion P2 is formed as a groove-shaped recessed space above the cooling space S between the first facing surface 11a of the lower plate member 11 and the second facing surface 10a of the upper plate member 10. The second flow path portion P2 is disposed at a position not communicating with the first upper flow path 21 and the second upper flow path 22.

In the cooling plate A, the temperature of the cooling liquid F flowing through the first upper flow path 21 is lower than the temperature of the cooling liquid F flowing through the cooling space S, the discharge flow path portion 24, and the second upper flow path 22.

As described above, the supply flow path portion 23 includes the plurality of (five) supply hole portions 23a linearly formed in an inclined orientation so as to supply the cooling liquid F from the first upper flow path 21 to the cooling space S. The plurality of (five) supply hole portions 23a are formed with the same inner diameter. The discharge flow path portion 24 includes the plurality of (five) discharge hole portions 24a linearly formed in an inclined orientation so as to discharge the cooling liquid F flowing into the cooling space S to the second upper flow path 22.

In particular, the plurality of discharge hole portions 24a forming the discharge flow path portion 24 and the plurality of supply hole portions 23a are formed in a common number and in a common shape in which the plurality of hole portions are disposed coaxially when viewed in plan view.

The five supply hole portions 23a and the five discharge hole portions 24a are disposed in parallel in a direction orthogonal to a direction in which the cooling liquid F flows, and drilled in the lower plate member 11 so as to be parallel to one another.

As illustrated in Fig. 4, when a center of the flow path of the supply hole portion 23a is set as a supply-side center line L1 and a center of the flow path of the discharge hole portion 24a is set as a discharge-side center line L2, in a side view, a supply-side inclination angle θ1 of the supply-side center line L1 with respect to the plate surface of the plate-shaped body 15 and a discharge-side inclination angle θ2 of the discharge-side center line L2 with respect to the plate surface of the plate-shaped body 15 are set to equal values.

The supply-side inclination angle θ1 and the discharge-side inclination angle θ2 do not need to be set to the same value and may be set to different values. The discharge flow path portion 24 does not need to be formed with the plurality of discharge hole portions 24a, and can be formed as a simple single hole having a width same as that of the cooling space S, for example. In the cooling plate A, even when the discharge flow path portion 24 is formed with the plurality of discharge hole portions 24a, the number of the discharge hole portions 24a may be set to be different from the number of the supply hole portions 23a.

The inverter 8 has a configuration in which a plurality of power control elements (electronic components) such as MOSFETs are supported on a lower side of the plate-shaped body 15 while being mounted on the substrate or the like. Accordingly, during power control in the inverter 8, heat from the plurality of power control elements is transferred to the plate-shaped body 15 by heat conduction. A heat conductive sheet may be interposed between the plate-shaped body 15 and the electronic component (which may be a substrate) in order to favorably conduct heat.

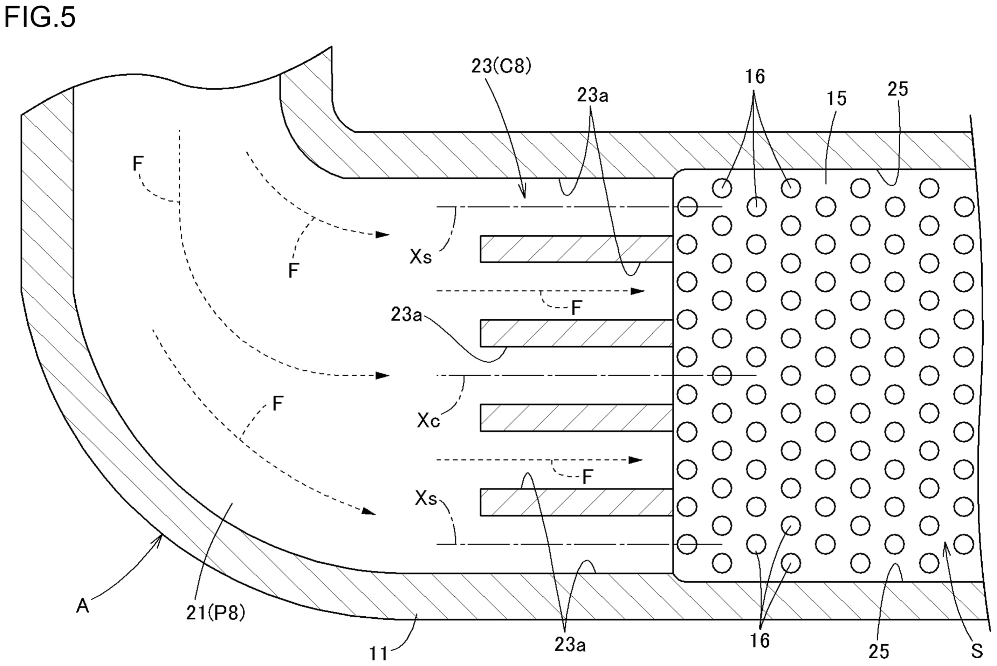

As illustrated in Figs. 3 and 5, the cooling liquid F is supplied to the supply flow path portion 23 after passing through a flow path portion of the first upper flow path 21 that is curved in plan view. In the cooling plate A, by making a total value of flow path cross-sectional areas of the plurality of (five) supply hole portions 23a smaller than a flow path cross-sectional area of the first upper flow path 21 at an upstream position in the vicinity of the supply flow path portion 23, a pressure of the cooling liquid F in the supply hole portion 23a is slightly increased, a flow velocity is increased, and at the same time, a flow rate of the cooling liquid F flowing through each of the plurality of (five) supply hole portions 23a is averaged.

That is, since the first upper flow path 21 at the upstream position of the supply flow path portion 23 is curved in plan view, the flow velocity of the cooling liquid F is different between a curvature center side of the curved flow path and an outer side thereof, and the flow rate of the cooling liquid F per unit time in a width direction of the flow path is different. On the other hand, by the setting of the flow path cross-sectional area, a pressure acting on upstream end portions of the plurality of (five) supply hole portions 23a is slightly increased, so that the flow rate of the cooling liquid F per unit time in each of the plurality of (five) supply hole portions 23a is made uniform.

As illustrated in Fig. 4, the cooling space S has a rectangular shape in a side view when the lower opening is closed by the plate-shaped body 15. Downstream end portions of the plurality of supply hole portions 23a communicate with corner portions of the cooling space S at an upper end.

As illustrated in Fig. 4, in a side view, a point (an intersection) where the supply-side center line L1 intersects the upper surface of the plate-shaped body 15 is referred to as a high-temperature region H. A position of the high-temperature region H is a position on the plate surface of the plate-shaped body 15 where the temperature is more likely to increase than other plate surfaces due to the heat of the inverter 8.

By setting the orientation of the supply hole portion 23a in this manner, efficient cooling can be performed by supplying the cooling liquid F directly to the high-temperature region H of the plate-shaped body 15. Since the supply hole portion 23a is connected to the cooling space S in such an orientation, a downstream end portion of the supply hole portion 23a is located at a position spaced apart above the lower surface of the cooling space S by a set distance.

As described above, since the orientation of the discharge hole portion 24a is the same as that of the supply hole portion 23a (an orientation that is line-symmetric in a side view), the downstream end portion of the discharge hole portion 24a is located at a position spaced apart above a bottom wall (a surface on which the pin fins 16 are formed) of the cooling space S by a set distance.

Further, the supply hole portion 23a and the discharge hole portion 24a are respectively connected to such positions, thereby avoiding interference with the seal 17. In the plate-shaped body 15, a region where the temperature is increased due to the heat of the inverter 8 is not limited to one location, and when there are a plurality of locations, an intersection between one of the locations and the supply-side center line L1 is set as the high-temperature region H.

As illustrated in Figs. 3 and 5, the plurality of pin fins 16 are disposed in parallel at set intervals in the width direction orthogonal to the direction in which the cooling liquid F flows in plan view (when viewed in the Z direction), and are arranged in a staggered pattern at set intervals in the direction in which the cooling liquid F flows. Among the plurality of pin fins 16, those disposed at an outer end position in the width direction are spaced apart from the inner side of the side wall 25 of the cooling space S in the width direction by a set distance.

As illustrated in Fig. 5, an opening portion of the supply hole portion 23a located at a center position (a position disposed in the central region) of the cooling space S in the width direction among the plurality of supply hole portions 23a is made to face a center between adjacent ones of the plurality of pin fins 16 disposed at the upstream end portion in the width direction among the plurality of pin fins 16.

That is, in the supply flow path portion 23, a relative positional relationship between the opening portion of the supply hole portion 23a and the pin fin 16 is set such that a central flow path center Xc of the supply hole portion 23a located at a center position in the width direction among the plurality of supply hole portions 23a is located in a central region of a pair of adjacent pin fins 16 in the width direction (at a position 1/2 the distance between the pair of pin fins 16). Accordingly, the cooling liquid F supplied from the opening portion of the supply hole portion 23a flows between the pair of pin fins 16 corresponding to the opening portion.

The opening portions of the supply hole portions 23a disposed at both end positions of the cooling space S in the width direction among the plurality of supply hole portions 23a face the plurality of pin fins 16 disposed at the upstream end portions among the plurality of pin fins 16. Accordingly, the relative positional relationship is set such that the cooling liquid F is directly supplied to the pin fins 16.

That is, the relative positional relationship between the supply hole portion 23a and the pin fin 16 is set such that an end flow path center Xs of the supply hole portions 23a disposed at both end positions in the width direction among the plurality of supply hole portions 23a intersects a center of a needle-shaped material forming the pin fin 16 in plan view. Accordingly, the cooling liquid F supplied from the opening portion of the supply hole portion 23a flows to collide with the corresponding pin fin 16.

As described above, since the positional relationship between the plurality of supply hole portions 23a and the plurality of pin fins 16 is set, the cooling liquid F supplied along the central flow path center Xc from the supply hole portion 23a in the central region of the cooling space S in the width direction among the plurality of supply hole portions 23a passes through a middle of the pin fin 16 disposed at the upstream end portion among the plurality of pin fins 16, smoothly flows without stagnation at the upper end position of the cooling space S in a supply direction of the cooling liquid F, and an area where the cooling liquid F comes into contact with the pin fin 16 can be increased.

On the other hand, the cooling liquid F supplied along the end flow path center Xs from the supply hole portions 23a disposed at both end positions of the cooling space S in the width direction among the plurality of supply hole portions 23a comes into contact with the pin fin 16 disposed at the upstream end portion among the plurality of pin fins 16 to collide therewith, is separated into the outer side and the inner side of the cooling space S in the width direction, and flows such that a part thereof comes into contact with the side wall 25 of the cooling space S.

The cooling liquid F flowing into the cooling space S in this manner passes through the plurality of discharge hole portions 24a of the discharge flow path portion 24 and is discharged from the discharge port Pb.

### Operational Effects of Embodiment

By supplying the cooling liquid F to the cooling flow path P inside the cooling plate A, heat from the electronic components on the plate surfaces 10b and 15a for heat exchange are absorbed to implement cooling of the electronic components.

The cooling plate A has a configuration in which the lower plate member 11 and the upper plate member 10 are overlapped and the cooling flow path P is formed on the mating surface thereof. Therefore, for example, a groove portion or a hole portion is formed along the mating surface between the lower plate member 11 and the upper plate member 10, and the lower plate member 11 and the upper plate member 10 are overlapped, so that the cooling flow path P can be formed.

For example, as compared with a configuration in which a flow path is formed inside by processing such as drilling a metal block, the cooling plate A having a configuration in which the lower plate member 11 and the upper plate member 10 are overlapped can form the cooling flow path P having a complicated shape by relatively easy processing.

In the cooling plate A, in the eighth flow path portion P8 for cooling the inverter 8, the total value obtained by adding up the flow path cross-sectional areas of the plurality of supply hole portions 23a forming the supply flow path portion 23 is set to be smaller than the flow path cross-sectional area of the first upper flow path 21 located upstream of the supply flow path portion 23.

Accordingly, when the cooling liquid F is supplied from the first upper flow path 21 to the supply flow path portion 23, the flow velocity of the cooling liquid F in the supply hole portion 23a is increased, and at the same time, the flow rate per unit time of the cooling liquid F flowing through each of the plurality of (five) supply hole portions 23a is averaged. As a result, when considering a space along the width direction of the cooling space S, an equal amount of cooling liquid F is supplied to each space, thereby eliminating imbalances in cooling performance in the width direction.

Since the supply flow path portion 23 is formed with the plurality of supply hole portions 23a in the inclined orientation progressively lower toward the downstream side, the flow velocity of the cooling liquid F increases due to the own weight thereof, and a decrease in flow velocity when the cooling liquid F comes into contact with the plurality of pin fins 16 in the cooling space S is prevented.

Through the eighth flow path portion P8, the cooling liquid F sent out from the supply hole portion 23a in the central region of the supply flow path portion 23 in the width direction among the plurality of supply hole portions 23a flows without causing a decrease in flow velocity in the plurality of pin fins 16, and stagnation of the cooling liquid F inside the cooling space S is prevented.

Through the eighth flow path portion P8, the cooling liquid F sent out from the supply hole portions 23a disposed at both end positions of the supply flow path portion 23 in the width direction among the plurality of supply hole portions 23a is actively brought into contact with the pin fin 16 disposed at the upstream end portion among the plurality of pin fins 16 to divide the cooling liquid F, and a part of the divided cooling liquid F is brought into contact with the inner surface of the side wall 25 of the cooling space S to implement an increase in cooling efficiency of the inverter 8.

The inverter 8 can be efficiently cooled by linearly supplying the cooling liquid F along the supply-side center line L1 illustrated in Fig. 4 to the high-temperature region H of the plate-shaped body 15 in which the temperature of the plate surface is higher than the temperature of the other plate surfaces due to the heat transferred from the electronic components.

### Other Embodiments

In addition to the above embodiment, this disclosure may be implemented as follows (those having the same functions as the embodiment are denoted by the same reference numerals as in the embodiment).
(a) The cooling plate A may be formed by stacking three or more plate members. The plate member may be made of a resin material. The cooling flow path P formed in the cooling plate A is not limited to the shape described in the embodiment, and may be set to a shape corresponding to the specification, for example.
(b) Instead of a configuration in which an opening formed in a lower surface of the lower plate member 11 is closed by the plate-shaped body 15 as in the embodiment, for example, the cooling plate A is formed such that the cooling space S as the second cooling flow path portion is formed inside a block-shaped plate member, for example, by processing a side surface of the plate member.

In the configuration of the other embodiment (b), the first cooling flow path portion (the first upper flow path 21) is formed as the cooling flow path P on the second facing surface 10a of the upper plate member 10, the second cooling flow path portion (the cooling space S) is formed in the lower plate member 11 by the above-described processing, and the cooling liquid F from the first cooling flow path portion (the first upper flow path 21) is supplied to the second cooling flow path portion (the cooling space S) by the supply flow path portion 23 in an inclined orientation.

In the other embodiment (b), a heat generating portion such as the inverter 8 is disposed on a lower surface side of the cooling space S in the lower plate member 11, and a plurality of fins (for example, the pin fins 16) are housed inside the cooling space S.

(c) The supply-side inclination angle θ1 of the supply flow path portion 23 and the discharge-side inclination angle θ2 of the discharge flow path portion 24 are set to different values in a side view.

(d) The number of the supply hole portions 23a is not limited to five, and may be any number. It is also conceivable that the supply flow path portion 23 is formed as a wide space, and the space is partitioned by a plurality of partition walls in an orientation along a flow direction of the cooling liquid F, so that the plurality of supply hole portions 23a are formed in an independent linear shape.

(e) Instead of a configuration in which directions in which the cooling liquid F flows from all of the plurality of supply hole portions 23a are set in a parallel orientation, in a side view, angles are set such that center lines of the plurality of supply hole portions 23a have different inclination angles in a longitudinal direction. Similarly, in plan view, the angles are set such that the center lines of the plurality of supply hole portions 23a are different from each other in a horizontal direction.

By setting the angles in the longitudinal direction or the angles in the horizontal direction to different values in this manner, even when a plurality of high-temperature regions H are present in the plate-shaped body 15, the cooling liquid F can be directly supplied individually to each of the high-temperature regions H, and effective cooling can be performed.

(f) Instead of the pin fins 16, a plurality of strip-shaped fins or a plate member formed in a wave shape may be used as the fins. When the plurality of fins are formed on the plate-shaped body 15, a relative positional relationship between positions of the respective fins and the plurality of supply hole portions 23a can be freely set.

As described above, although shapes of the fins are not limited to a specific shape, it is desirable that the fins are disposed at intervals set in a width direction in the cooling space S. The disposition of the plurality of fins is not limited to a staggered disposition, and the plurality of fins may be disposed at intervals set in the width direction and the flow direction of the cooling liquid F, or may be disposed such that the plurality of fins are randomly disposed in plan view.

(g) The plurality of supply hole portions 23a forming the supply flow path portion 23 are not limited to be disposed in a row in a width direction, and for example, the plurality of supply hole portions 23a may be disposed in a plurality of stages vertically. The plurality of supply hole portions 23a may have different flow path cross-sectional areas.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

In the embodiment described above, the following configurations are conceivable.
(1) The cooling plate A for cooling an electronic component (the inverter 8) to be cooled by the cooling liquid F flowing through the cooling flow path P, the cooling plate A including: a pair of plate members 10 and 11 one of which has a plate surface 15a with which the electronic component (the inverter 8) comes into contact, in which the cooling flow path P is formed in at least one of the pair of plate members 10 and 11, the cooling flow path P includes a first cooling flow path portion (the first upper flow path 21), a second cooling flow path portion (the cooling space S) located downward further than the first cooling flow path portion (the first upper flow path 21) and downstream in a flow direction of the cooling liquid F, and the supply flow path portion 23 inclined downward to connect the first cooling flow path portion (the first upper flow path 21) and the second cooling flow path portion (the cooling space S), a plurality of fins (the pin fins 16) formed on the one of the plate members 10 and 11 are housed in the second cooling flow path portion (the cooling space S), and the electronic component (the inverter 8) comes into contact with a portion of the plate surface 15a that is close to the second cooling flow path portion (the cooling space S).

According to this, since the cooling flow path P is formed in at least one of the pair of plate members 10 and 11, a duct or a conduit for forming a flow path is not required, and the number of components can be reduced. Since the cooling liquid F from the first cooling flow path portion (the first upper flow path 21) flows downward through the supply flow path portion 23 in the inclined orientation and is supplied to the second cooling flow path portion (the cooling space S), the flow is promoted by the weight of the cooling liquid F, the cooling liquid F is easily brought into contact with the plurality of fins (the pin fins 16) in the second cooling flow path portion (the cooling space S), and the temperature of the heat generating portion is easily reduced.

(2) In the cooling plate A in (1), it is preferable that the supply flow path portion 23 includes a plurality of supply hole portions 23a configured to allow the cooling liquid F to be sent linearly toward the second cooling flow path portion (the cooling space S), and a total value of flow path cross-sectional areas of the plurality of supply hole portions 23a is smaller than a flow path cross-sectional area of the first cooling flow path portion (the first upper flow path 21) at a position upstream of the supply flow path portion 23.

According to this, since a pressure acting on upstream end portions of the plurality of supply hole portions 23a is increased, a flow velocity of the cooling liquid F in the plurality of supply hole portions 23a is increased, and at the same time, a flow rate of the cooling liquid F flowing through each of the plurality of supply hole portions 23a is averaged.

(3) In the cooling plate A in (2), it is preferable that, when viewed in a direction orthogonal to the plate surfaces 10b and 15a of a corresponding one of the plate members 10 and 11, the plurality of fins (the pin fins 16) are disposed in parallel in a width direction orthogonal to the flow direction of the cooling liquid F, the supply hole portion 23a disposed in a central region in the width direction among the plurality of supply hole portions 23a includes an opening portion facing a space between the pair of fins (the pin fins 16) that are adjacent to each other in the width direction, and the supply hole portion 23a disposed at an end portion in the width direction among the plurality of supply hole portions 23a includes an opening portion facing the fin (the pin fin 16) at an end portion in the width direction.

According to this, when viewed in the direction orthogonal to the plate surfaces 10b and 15a of the plate member 10 and 11, among the plurality of supply hole portions 23a, the supply hole portion 23a disposed in the central region in the width direction includes the opening portion facing the space between the pair of fins (the pin fins 16) adjacent to each other in the width direction, so that the cooling liquid F sent out from the opening flows between the pair of fins (the pin fins 16) without stagnation, and an area where the cooling liquid F comes into contact with the fins (the pin fins 16) can be increased. Since the opening portion of the supply hole portion 23a disposed at the end portion in the width direction among the plurality of supply hole portions 23a faces the fin (the pin fin 16) at the end portion in the width direction, the cooling liquid F sent out from the opening is brought into contact with the fin (the pin fin 16) to collide therewith, the cooling liquid F is separated and flows to an outer side and an inner side of the cooling space S in the width direction by the contact, and a part of the cooling liquid F flows to come into contact with the side wall 25 of the cooling space S, thereby implementing good cooling.

(4) In the cooling plate A in any one of (1) to (3), it is preferable that the plate surface 15a includes the high-temperature region H having a temperature higher than that in other regions due to heat transferred from the electronic component, and an inclination angle (the supply-side inclination angle θ1) of the supply flow path portion 23 is set to an angle at which the cooling liquid F is supplied toward the high-temperature region H.

According to this, by setting an orientation of the supply hole portion 23a, the cooling liquid F can be directly supplied to the high-temperature region H of the plate-shaped body 15 to perform efficient cooling.

### Industrial Applicability

This disclosure can be used for a cooling plate.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A cooling plate (A) for cooling an electronic component (8) to be cooled by a cooling liquid (F) flowing through a cooling flow path (P), the cooling plate comprising:
a plate member (10, 11) having a plate surface (10b, 15a) with which the electronic component comes into contact, wherein
the cooling flow path is formed in the plate member,
the cooling flow path includes a first cooling flow path portion (21), a second cooling flow path portion (S) located downward further than the first cooling flow path portion in a gravity direction and downstream in a flow direction of the cooling liquid, and a supply flow path portion (23) inclined downward to connect the first cooling flow path portion and the second cooling flow path portion,
a plurality of fins (16) formed on the plate member are housed in the second cooling flow path portion, and
the electronic component comes into contact with a portion of the plate surface that is close to the second cooling flow path portion.

2. The cooling plate according to claim 1, wherein
the supply flow path portion includes a plurality of supply hole portions (23a) that are linearly shaped toward the second cooling flow path portion, and
a total value of flow path cross-sectional areas of the plurality of supply hole portions is smaller than a flow path cross-sectional area of the first cooling flow path portion located upstream of the supply flow path portion in the flow direction.

3. The cooling plate according to claim 2, wherein
when viewed in a direction orthogonal to the plate surface of the plate member, the plurality of fins are disposed in parallel in a width direction orthogonal to the flow direction of the cooling liquid,
the supply hole portion disposed in a central region in the width direction among the plurality of supply hole portions includes an opening portion facing a space between a pair of the fins that are adjacent to each other in the width direction, and
the supply hole portion disposed at an end portion in the width direction among the plurality of supply hole portions includes an opening portion facing the fin at an end portion in the width direction.

4. The cooling plate according to any one of claims 1 to 3, wherein
the plate surface includes a high-temperature region (H) having a temperature higher than that in other regions due to heat transferred from the electronic component, and
an inclination angle (θ1) of the supply flow path portion is set to an angle at which the cooling liquid is supplied toward the high-temperature region.
